# EUROPÄISCHE PATENTSCHRIFT

(11) **EP 2 234 749 B1**
(45) Veröffentlichungstag und Bekanntmachung des Hinweises auf die Patenterteilung: **05.02.2020**
(21) Anmeldenummer: 08861632.1
(22) Anmeldetag: 05.12.2008
(51) Int. Cl.: B23K 1/00

(54) **Verfahren zur Herstellung einer Lötverbindung zwischen zwei Bauteilen**
Method for producing a soldered connection between two components
Procédé pour la réalisation d'une liaison brasée entre deux éléments

(30) Priorität: 14.12.2007 DE 102007060971
(43) Veröffentlichungstag der Anmeldung: 06.10.2010
(73) Patentinhaber: Fraunhofer-Gesellschaft zur Förderung der angewandten Forschung e.V., 80686 München (DE)
(72) Erfinder: DOLKEMEYER, Jan, 52072 Aachen (DE); STROTKAMP, Michael, 52064 Aachen (DE); FUNCK, Max, 52064 Aachen (DE); STOLLENWERK, Jochen, NL-6228 CD Maastricht (NL)
(74) Vertreter: Naeven, Ralf
(86) Internationale Anmeldenummer: PCT/DE2008/002008
(87) Internationale Veröffentlichungsnummer: WO 2009/076930

(56) Entgegenhaltungen:
- DE-A1- 1 926 093
- DE-A1- 2 629 496
- DE-A1-102004 060 703
- DE-C1- 19 741 557

## Beschreibung

Die Erfindung betrifft ein Verfahren zur Herstellung einer Lotverbindung zwischen zwei nicht metallisch leitenden Bauteilen gemäß dem Oberbegriff des Anspruchs 1.

Bei bekannten Widerstandslötverfahren wird Lotmaterial mittels elektrischen Stroms aufgeschmolzen. Dabei kann der elektrische Strom durch mindestens eines der beteiligten Bauteile geführt werden. So offenbart die DE 197 41 557 ein Verfahren zum Aufbringen von Lötmaterial auf vornehmlich elektrofeinmechanische Bauteile, wobei ein Bauteil mit einer Elektrode in Kontakt steht und das Lotmaterial in fester Form aufgebracht und durch eine zweite Elektrode kontaktiert wird, die gleichzeitig mit einer vorgegebenen Kraft das Lotmaterial auf das Bauteil drückt. Durch die aufgrund des elektrischen Widerstandes erzeugte thermische Energie werden das Bauteil sowie das Lotmaterial so weit erhitzt, dass das Lotmaterial schmilzt und sich mit dem Bauteil verbindet. Vor dem Erkalten des Lotmaterials wird die dem Lotmaterial zugewandte Elektrode abgehoben.

Die DE 103 35 111 offenbart ein Montageverfahren zur Verbindung eines Halbleiterbauteils mit zwei Metallplatten. Hierfür wird auf zwei gegenüberliegende Seiten des Halbleiterbauteils jeweils Lotmaterial aufgebracht, das wiederum jeweils eine Metallplatte kontaktiert. Durch die beiden Metallplatten, die beiden Lotschichten sowie das dazwischen liegende Halbleiterbauteil wird ein Strom geleitet, der das Halbleiterbauteil auf eine das Aufschmelzen des Lotmaterials bewirkende Temperatur erhitzt.

Die beschriebenen Verfahren haben den Nachteil, dass der zur Erhitzung des Lotmaterials notwendige elektrische Strom jeweils auch mindestens ein Bauteil passieren muss. Bei elektrisch isolierenden Bauteilen oder solchen Bauteilen, die bei den benötigten Stromstärken beschädigt werden können, wäre diese Vorgehensweise nicht möglich.

Um einen elektrischen Strom durch ein Bauteil hindurch zu vermeiden, ist vorgeschlagen worden (DE 195 40 140), einen gesonderten Heizwiderstand vorzusehen, der an einer Seite eines Substrats angeordnet ist, welche der Lotstelle auf dem Substrat gegenüberliegt. Dabei wird die thermische Energie durch das Substrat hindurch zum Lotmaterial geführt, weshalb das Substrat eine hinreichende thermische Leitfähigkeit aufweisen muss. Nachteilig ist auch, dass diese Vorgehensweise keine vollständig beidseitige Montage von Bauteilen auf dem Substrat erlaubt, da Platz für den Heizwiderstand benötigt wird. Die für das Anbringen des Heizwiderstandes notwendig Metallisierung des Substrats ist zudem kostentreibend. Schließlich kann sich das Substrat auf Grund der unterschiedlich strukturierten Metallisierung der beiden Seiten bei dessen Erwärmung verformen.

Des Weiteren ist es bekannt, das Lotmaterial allein mit Laserstrahlung aufzuheizen. Dies hat den Vorteil, dass sehr gezielt geometrisch genau abgrenzbare Bereiche erhitzt werden können. Hierfür muss das Laserlicht aber durch ein Bauteil hindurch, z.B. durch eine Grundplatte, auf das Lotmaterial gerichtet werden, was nur bei optisch transparenten Materialien möglich ist. Bei einer Erhitzung durch die Grundplatte hindurch muss zudem eine in der Regel notwendige Metallisierung der Grundplatte strukturiert werden, damit das Laserlicht das Lotmaterial erreichen kann.

Aus der DE 10 2004 060 703 A1 ist ein Verfahren zum Anbringen von Lotmaterial an einem Bauteil bekannt, bei dem das Lotmaterial auf das Bauteil aufgelegt wird und anschließend über zwei das Lotmaterial unmittelbar kontaktierende Elektroden ein Heizstrom in das Lotmaterial eingegeben wird, damit dieses anschmilzt und eine Verbindung mit dem Bauteil eingeht. Hierdurch ist das Bauteil für eine Lotverbindung mit einem weiteren Bauteil vorbereitet. In demselben Dokument ist dann des Weiteren offenbart, zwei auf diese Weise mit Lotmaterial versehene Bauteile mit den gelöteten Seiten aufeinander zu legen und in das obere, metallisch leitende Bauteil einen Strom zu geben, so dass sich dieses erwärmt und über die Wärmeleitung auch die Lotschicht zwischen den beiden Bauteilen erwärmt wird, damit es zu einer Verbindung kommt. Somit ist auch hier für die Herstellung der Lotverbindung zwischen zwei Bauteilen ein Strom durch eines der Bauteile notwendig.

Die DE 19 26 093 A offenbart ein Lötverfahren bei dem ein vorzugsweise ultradünner isolierter Metalldraht auf ein leitendes Auflager unter Einsatz eines Auflagerwerkstoffes aufgelötet werden soll, wobei der Isolierstoff und der Auflagerwerkstoff verdampft werden. Bei diesem Verfahren wird eine Elektrode gegen den Metalldraht gedrückt, und ein Strom fließt über Elektrode, Metalldraht und Auflager.

Aus der DE 103 50 707 ist ein Verfahren zur Herstellung eines elektrischen Kontakts für einen optoelektrischen Halbleiterchip offenbart, bei dem eine Lotschicht mittels PVD-Technik oder galvanischer Abscheidung aufgebracht wird. Die Herstellung einer Lotverbindung zwischen zwei Bauteilen ist nicht angesprochen. DE 26 29 496 offenbart ein Verfahren zur Herstellung einer Lotverbindung gemäß dem Oberbegriff des Anspruchs 1

Es ist nun Aufgabe der vorliegenden Erfindung, ein Verfahren der eingangs genannten Art zur Verfügung zu stellen, mit dem eine lokal eingegrenzte Einkopplung thermischer Energie bei möglichst symmetrischer Aufheizung der Fügepartner möglich ist, wobei einerseits der Einsatz von Strahlung oder gesonderter Heizelemente und andererseits die Beaufschlagung der beteiligten Bauteile mit elektrischem Strom vermieden werden kann.

Diese Aufgabe wird bei einem Verfahren gemäß Anspruch 1 gelöst, bei dem eine Lotschicht auf mindestens eine für die Verbindung der Bauteile vorgesehene Verbindungsfläche zumindest eines der beiden Bauteile aufgebracht wird und zum Aufschmelzen zumindest eines Teils des Lots ein über zwei unterschiedlich gepolte Elektroden eingespeister elektrischer Strom durch die Lotschicht geführt wird, wobei beide Elektroden unmittelbar die Lotschicht kontaktieren.

Vorliegend sind mit der Bezeichnung "Bauteil" alle möglichen Fügepartner gemeint, z.B. optische, elektronische oder optoelektronische Komponenten wie auch passive Elemente wie Grundplatten. Die Bauteile sind nicht metallisch leitend. Jedenfalls soll ein beteiligtes Bauteil an seiner die Lotschicht kontaktierenden Oberfläche nicht oder zumindest nicht vollständig metallisch leitend sein, damit der in das Lotmaterial eingespeiste elektrische Strom im Wesentlichen in der Lotschicht verbleibt.

Mit dem erfindungsgemäßen Verfahren ist ein Widerstandslötverfahren gegeben, bei dem der elektrische Strom selektiv durch die Lötschicht geführt wird, während die beteiligten Bauteile nicht oder im Wesentlichen nicht mit Strom beaufschlagt werden. Auf diese Weise wird die thermische Energie nur dort eingekoppelt, wo sie benötigt wird. Das Aufschmelzen des Lotmaterials geschieht bevorzugt, wenn die beiden miteinander zu verbindenden Bauteile über das Lotmaterial bereits in Kontakt zueinander stehen. Beim Aufheizen und Aufschmelzen des Lotmaterials werden beide Bauteile bei einander entsprechenden Geometrien im Wesentlichen in gleicher Weise mit thermischer Energie belastet, wobei diese Belastung auf das Mindestmaß beschränkt bleibt, da nur das Lot unmittelbar durch elektrischen Strom aufgeheizt wird. Durch Wärmeleitung werden gleichzeitig die beteiligten Fügepartner im Bereich der Fügung auf Löttemperatur gebracht, wodurch gesonderte Maßnahmen zur Erwärmung der beteiligten Bauteile entfallen können. Da hierfür lediglich ein kurzes Aufschmelzen des Lotmaterials ausreichend sein kann, können sehr kurze Prozesszeiten erreicht werden. Hierdurch und durch den unmittelbaren Kontakt beider Fügepartner mit dem Lotmaterial ist außerdem eine Schutzgas-Atmosphäre zum Schutz vor Oxidation des Lotmaterials nicht erforderlich.

Die in die Lotschicht eingekoppelte thermische Energie ist zudem auf einfache Weise, schnell und mit einem direkten Prozessfeedback über die in der Lotschicht abfallende elektrische Leistung regelbar, wodurch der Prozess weiter optimiert werden kann.

Als Folge der vorgenannten Vorteile ermöglicht oder unterstützt das erfindungsgemäße Verfahren eine zeitsparende und preisgünstige Serienfertigung, insbesondere auch in der Herstellung von elektro-optischen Systemen, da die klassische Handmontage durch einen voll- oder halbautomatisierten Lötprozess ersetzt werden kann. Zudem ist das Verfahren nicht auf bestimmte Lot- oder Bauteilmaterialien oder Bauteilarten beschränkt.

Das erfindungsgemäße Verfahren kann auch so ausgeführt werden, dass die Lotschicht mittels physikalischer oder chemischer Gasphasenabscheidung aufgebracht wird. Des Weiteren kann die Lotschicht mittels galvanischer Abscheidung aufgebracht werden.

Mit den genannten Verfahren ist durch eine geeignete Maskierung ein selektives Aufbringen auf scharf abgegrenzte Flächen möglich, was eine hohe Dichte der zum Beispiel auf einer Grundplatte anzubringenden Bauteile erlaubt.

Das erfindungsgemäße Verfahren kann auch so ausgeführt werden, dass zur Herstellung von für den elektrischen Kontakt mit Elektroden vorgesehenen Kontaktierungsflächen die Lotschicht über die Verbindungsfläche hinaus aufgebracht wird. Hierdurch wird die elektrische Kontaktierung der Lotschicht vereinfacht, indem zum Beispiel die Elektroden unmittelbar neben dem auf eine Grundplatte aufzubringenden Bauteil auf die Kontaktierungsflächen aufgesetzt werden.

Es kann vorteilhaft sein, das erfindungsgemäße Verfahren so auszuführen, dass die Lotschicht im Bereich der Verbindungsfläche in der vorgesehenen Stromrichtung gesehen mit einer gegenüber den Kontaktierungsflächen geringeren Querschnittsfläche aufgebracht wird. Hierdurch wird erreicht, dass die Stromdichte im Bereich der Verbindungsfläche höher ist als im Bereich der Kontaktierungsflächen. Bei geeigneter Stromstärke wird die Lotschicht im Bereich der Verbindungsfläche lokal aufgeschmolzen, in den Kontaktierungsflächen hingegen nicht. Die unterschiedlichen Querschnittsflächen für Verbindungsflächen und Kontaktierungsflächen können durch eine geeignete Maskierung beim Auftragen der Lotschicht erreicht werden. Dabei ist es denkbar, die größere Querschnittsfläche durch eine größere laterale Ausdehnung der Lotschicht in den Kontaktierungsflächen zu erreichen. Um die flächenmäßige Ausdehnung der Kontaktierungsflächen auf der Grundplatte möglichst gering zu halten, ist es alternativ möglich, in den Kontaktierungsflächen eine gegenüber der Verbindungsfläche größere Schichtdicke vorzusehen.

Es ist aber auch möglich, das erfindungsgemäße Verfahren so auszuführen, dass die bereits aufgebrachte Lotschicht im Bereich der Verbindungsfläche in ihrer Querschnittsfläche in der vorgesehenen Stromrichtung gesehen verringert wird. Dies kann durch eine aktive Strukturierung der Lotschicht, z.B. mit Hilfe von Laserstrahlung erfolgen, indem im Bereich der Verbindungsfläche nach ihrem Aufbringen ein Teil der Lotschicht wieder entfernt wird.

Das erfindungsgemäße Verfahren kann auch so ausgeführt werden, dass bei vorgegebener Stromstärke in der mindestens einen Verbindungsfläche die Stromdichte in der Lotschicht mittels mindestens eines magnetischen Feldes erhöht wird. Das Magnetfeld kann den Strom innerhalb der Verbindungsfläche auf eine geringere Querschnittsfläche bündeln, wodurch die Stromdichte und damit die in der Verbindungsfläche entwickelte thermische Energie erhöht wird.

Schließlich kann das erfindungsgemäße Verfahren so ausgeführt werden, dass vor dem Aufbringen der Lotschicht mindestens eines der Bauteile mit einer lotfähigen Schicht versehen wird. Diese Vorgehensweise wird zum Beispiel bei Keramiken, wie sie in der Regel für elektrisch nicht leitende Grundplattenmaterialien verwendet werden, notwendig sein. Die Beschichtung kann dabei teil- oder vollflächig erfolgen. Wie auch später das Lotmaterial kann die lötfähige Beschichtung mittels physikalischer oder chemischer Gasphasenabscheidung oder galvanischer Abscheidung erfolgen. Die lotfähige Beschichtung oder gegebenenfalls in der Summe die beiden lotfähigen Beschichtungen der beiden Bauteile sollten einen größeren elektrischen Widerstand als die Lotschicht aufweisen, um die Widerstandserwärmung des Lotmaterials wirkungsvoll durchführen zu können.

Eine Vorrichtung zur Durchführung des Verfahrens kann so ausgebildet sein, dass die Vorrichtung eine Greifeinheit zum Greifen eines ersten Bauteils sowie Mittel zum Verfahren der Greifeinheit aufweist und die Elektroden zur unmittelbaren Kontaktierung einer an einem zweiten Bauteil vorgesehenen und mit dem ersten Bauteil in Kontakt stehenden Lotschicht hergerichtet sind.

Die Elektroden können gemeinsam oder getrennt angesteuert zur Kontaktierung an die zu erwärmende Lotschicht geführt werden.

Dabei kann es vorteilhaft sein, die Vorrichtung so auszubilden, dass die Elektroden an der Greifeinheit angeordnet sind. Befinden sich nämlich die Kontaktierungsflächen der Lotschicht unmittelbar neben der Verbindungsfläche, können die Elektroden durch das Absenken der Greifeinheit mitsamt dem gegriffenen Bauteil auf das andere Bauteil, zum Beispiel auf eine Grundplatte, abgesenkt werden. Auf diese Weise wird durch eine einzige Bewegung der Greifeinheit sowohl das Bauteil in die vorgesehene Position gebracht als auch die Elektroden auf die Kontaktierungsflächen abgesenkt. Hierdurch kann der Lötvorgang in extrem kurzer Zeit und mit einem gegenüber einer separaten Elektrodensteuerung geringeren apparativen Aufwand durchgeführt werden.

Im Folgenden werden beispielhafte Ausführungsbeispiele des erfindungsgemäßen Verfahrens anhand von Figuren dargestellt.

Es zeigen schematisch:
- Fig. 1:: eine Grundplatte, eine Greifeinheit und eine Komponente im Moment des Lötens,
- Fig. 2:: eine Anordnung ähnlich der in Fig. 1 mit geänderter Elektrodenanordnung,
- Fig. 3 - 6:: Grundplatten in Aufsicht mit verschiedenen Geometrien der Lotschicht.

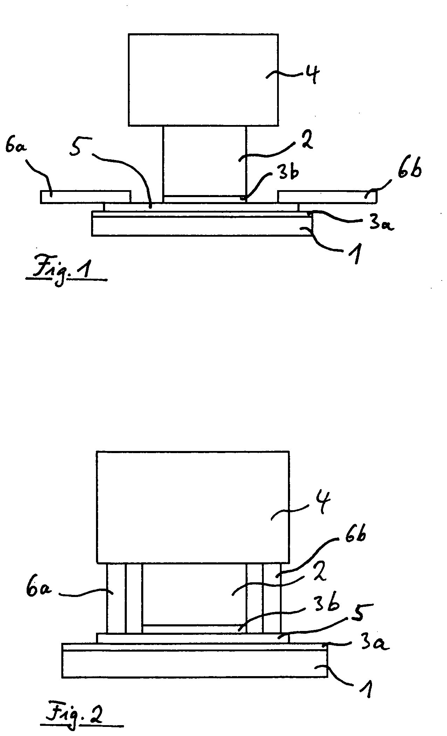

Figur 1 zeigt im Querschnitt einen Ausschnitt aus einer Grundplatte 1, auf die eine optoelektronische Komponente 2 gelötet wird. Bei der Grundplatte 1 handelt es sich um eine Keramik, zum Beispiel aus AlN oder Al₂O₃. Die Grundplatte 1 wurde mit einer lötfähigen Beschichtung 3a, zum Beispiel aus Gold, versehen. Die lötfähige Beschichtung kann dabei vollflächig die gesamte Grundplatte 1 bedecken oder im Wesentlich auf die Bereiche beschränkt sein, die für Lötvorgänge vorgesehen sind. Auch die Komponente 2 weist eine lötfähige Beschichtung 3b auf. Die Komponente 2 wird durch einen Greifer 4 gehalten, wobei es sich um einen Vakuumgreifer handeln kann, der die Komponente 2 mittels eines Unterdrucks im Greifer 4 hält. Auf die lötfähige Beschichtung 3a der Grundplatte 1 ist durch einen weiteren Beschichtungsvorgang eine Lotschicht 5, z.B auf Zinnbasis, aufgebracht. Das Aufbringen der lotfähigen Schichten sowie der Lotschicht erfolgt z.B. in einer Aufdampfanlage.

In einer Lötanlage wird für den Lötvorgang mittels des Greifers 4 die Komponente 2 auf der Lotschicht 5 abgesetzt. Anschließend oder gleichzeitig wird die Lotschicht 5 mit Elektroden 6a und 6b kontaktiert, die an eine hier nicht dargestellte Spannungsquelle angeschlossen sind. Durch Schließen des Stromkreises fließt ein Strom durch die Lotschicht 5, die bei geeigneter Stromstärke aufschmilzt. Sobald ein hinreichender Aufschmelzgrad erreicht ist, werden die Elektroden 6a und 6b von der Lotschicht 5 entfernt, wodurch der Stromkreis unterbrochen wird. Zur Automatisierung sich wiederholender Vorgänge kann ein hinreichender Aufschmelzgrad beim ersten Lötprozess dieser Art festgestellt werden. Die maßgeblichen Parameter, wie Zeit und Stromstärke, werden gespeichert und bei Folgevorgängen automatisiert eingesetzt. Es ist auch möglich, die für einen hinreichenden Aufschmelzgrad der Lotschicht 5 notwendige thermische Energie in Abhängigkeit vom Lötmaterial und seiner geometrischen Verteilung zu berechnen oder empirisch zu bestimmen und die einzukoppelnde thermische Energie über den Leistungsabfall in der Lotschicht 5 zu regeln. Nach dem Unterbrechen des Stromkreises erkaltet und erstarrt die Lotschicht 5 und verbindet so über die jeweiligen lötfähigen Beschichtungen 3a und 3b die Komponente 2 mit der Grundplatte 1. Daraufhin kann der Greifer 4 belüftet werden, wodurch die Komponente 2 vom Greifer 4 gelöst wird.

Figur 2 zeigt ebenfalls eine Grundplatte 1 mit lötfähiger Beschichtung 3a, eine Komponente 2 mit lötfähiger Beschichtung 3b sowie einen Greifer 4, der die Komponente 2 hält und die Komponente 2 mittels einer hier nicht dargestellten Verfahreinheit verfahren kann. Des Weiteren ist eine Lotschicht 5 aufgebracht. Anders als in der Vorrichtung gemäß Figur 1 sind die Elektroden 6a und 6b unmittelbar am Greifer 4 angeordnet. Damit werden die Elektroden 6a und 6b zusammen mit der Komponente 2 verfahren, weshalb sich eine oder zwei separate Verfahreinheiten für die Elektroden 6a und 6b erübrigen. Die Elektroden 6a und 6b sind in ihrer Längsrichtung jeweils innerhalb des Greifers 4 federnd gelagert, so dass die Elektroden 6a, 6b mit ihren dem Greifer 4 abgewandten Enden das entsprechende Ende der Komponente 2 überragen. Beim Absenken des Greifers 4 in Richtung auf die Grundplatte 1 berühren daher zuerst die Elektroden 6a und 6b die Lotschicht 5. Beim weiteren Absenken des Greifers 4 werden die Elektroden 6a und 6b ein Stück weit in den Greifer 4 hineingedrückt, bis dann auch die Komponente 2 mit seiner lötfähigen Beschichtung 3b auf der Lotschicht 5 aufsitzt. Wenn der Stromkreis geschlossen wird, fließt ein Strom durch die Lotschicht 5 und schmilzt diese auf. Das Schließen des Stromkreises kann unmittelbar durch das Aufsetzen der Elektroden oder durch einen separaten Schaltvorgang erfolgen. Bei hinreichendem Aufschmelzungsgrad gibt der Greifer 4 die Komponente 2 frei und wird von der Komponente 2 abgehoben, wodurch gleichzeitig die Elektroden 6a und 6b von der Lotschicht 5 entfernt werden. Hierdurch oder durch einen separaten Schaltvorgang wird der Stromkreis unterbrochen, wodurch die Lotschicht 5 erkaltet und die gewünschte Lötverbindung zwischen der Komponente 2 und der Grundplatte 1 geschaffen wird.

Alternativ kann zu der Vorrichtung gemäß Fig. 2 auch vorgesehen werden, innerhalb des Greifers 4 Verfahreinheiten für die Elektroden 6a, 6b vorzusehen. Dadurch können die Elektroden 6a und 6b von der aufgeschmolzenen Lotschicht 5 abgehoben werden, während der Greifer 4 noch zur Ausübung eines auf die Komponente 2 wirkenden Anpressdruckes in seiner Position verbleibt.

Weiter alternativ kann vorgesehen werden, die Lotschicht 5 so zu strukturieren, dass diese nur lokal, nämlich im Bereich unterhalb der Komponente 2, aufschmilzt, während im Bereich des Kontaktes zwischen den Elektroden 6a und 6b mit der Lotschicht 5 das Lotmaterial noch fest bleibt. Wenn dann der Stromkreis unterbrochen wird, kommt es nicht zu einer Lötverbindung zwischen den Elektroden 6a bzw. 6b und der Grundplatte 1, während der Greifer 4 die Komponente 2 noch auf das erstarrende Lotmaterial der Lotschicht 5 presst und damit die Ausbildung einer stabilen Lötverbindung unterstützt. Erst nach dem vollständigen Erstarren der Lotschicht 5 löst sich der Greifer von der Komponente 2 und hebt die Elektroden 6a und 6b von der Lotschicht 5 ab.

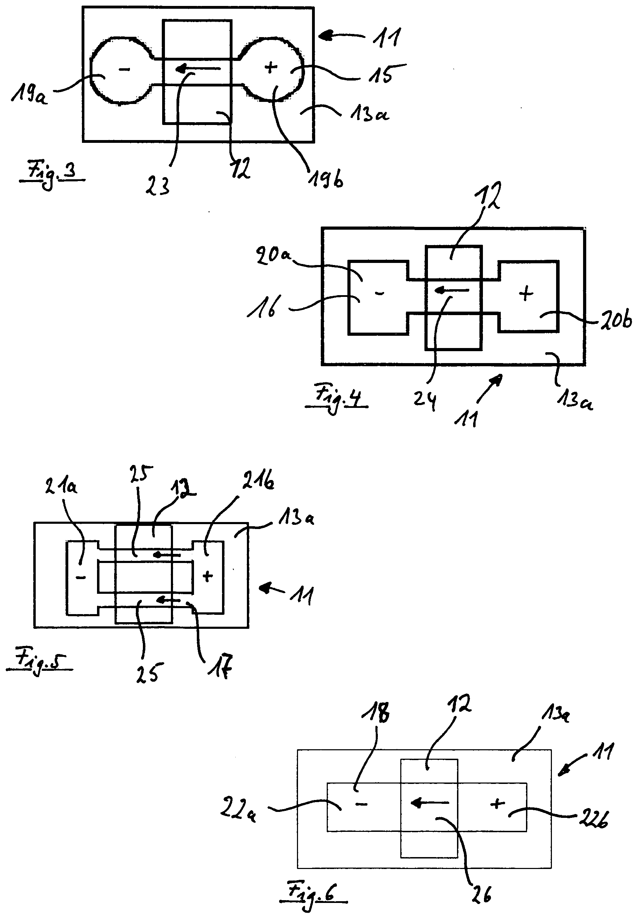

Die Figuren 3 bis 6 zeigen in Aufsicht ausschnittweise eine Grundplatte 11, die jeweils mit einer lotfähigen Beschichtung 13a versehen ist, die den gesamten Ausschnitt der Grundplatte 11 bedeckt. Auf den lötfähigen Beschichtungen 13a ist in den Figuren 3 bis 6 jeweils eine Lotschicht 15, 16, 17 bzw. 18 in unterschiedlichen Geometrien aufgebracht. Des Weiteren sind die Umrisse einer Komponente 12 dargestellt, die auf die Grundplatte 11 gelötet werden soll. Die Lotschicht 15, 16, 17 bzw. 18 lässt sich in Kontaktierungsflächen 19a und 19b, 20a und 20b, 21a und 21b bzw. 22a und 22b sowie jeweils eine Verbindungsfläche 23, 24, 25 bzw. 26 aufteilen. Die Kontaktierungsflächen sind für den Kontakt mit den in den Fig. 3 bis 6 nicht dargestellten Elektroden vorgesehen. Eine mögliche Stromrichtung ist jeweils durch einen Pfeil gekennzeichnet, die zugehörigen Polung durch Plus- und Minuszeichen. In den Geometrien gemäß den Figuren 3 bis 5 zeichnet sich die Verbindungsfläche 23, 24 und 25 dadurch aus, dass ihre Querschnittsfläche in Richtung des zur Erwärmung der Lotschicht 15 eingesetzten Stromes gesehen geringer ist als der der Kontaktierungsflächen 19a und 19b, 20a und 20b bzw. 21a und 21b. In Figur 5 ist die Besonderheit gegeben, dass die Verbindungsfläche 25 auf zwei Streifen aufgeteilt ist. Die Geometrie der aufgebrachten Lotschicht 15 bis 18 kann durch eine entsprechende Maskierung während des Aufbringens der Lotschicht 15 bis 18 und/oder durch Strukturierung mittels Laserstrahls oder durch einen auf andere Weise erreichten gezielten Abtrag des Lotmaterials erreicht werden.

Der verringerte Querschnitt der Lotschicht 15 bis 17 in den Geometrien gemäß den Figuren 3 bis 5 bewirkt in der jeweiligen Verbindungsfläche 23, 24 und 25 eine gegenüber den zugehörigen Kontaktierungsflächen 19a und 19b, 20a und 20b bzw. 21a und 21b höhere Stromdichte, so dass das Lotmaterial nur im Bereich der jeweiligen Verbindungsfläche 23, 24 bzw. 25 aufgeschmolzen wird.

In der Geometrie gemäß Figur 6 bleibt die Querschnittsfläche über die gesamte Lotschicht 18 konstant. Bei dieser Konstellation wird in Kauf genommen, dass das Lotmaterial auch im Bereich der Kontaktierungsflächen 22a und 22b, also dort, wo die hier nicht dargestellten Elektroden aufsitzen, aufschmilzt. Hier ist es erforderlich, dass die Elektroden vor der Verfestigung des Lotmaterials von der Lotschicht 18 abgehoben werden.

Die beschriebenen Lötverfahren können z.B. mittels einer NC-Steuerung voll- oder halbautomatisch durchgeführt werden

### Bezugszeichenliste

- 1: Grundplatte
- 2: Komponente
- 3a, 3b: lötfähige Beschichtung
- 4: Greifer
- 5: Lotschicht
- 6a, 6b: Elektroden
- 11: Grundplatte
- 12: Komponente
- 13a: lötfähige Beschichtung
- 15 bis 18: Lotschicht
- 19 bis 22: Kontaktierungsfläche
- 23 bis 26: Verbindungsfläche

## Patentansprüche

1. Verfahren zur Herstellung einer Lotverbindung zwischen zwei Bauteilen (1,2,11,12),
bei dem
eine Lotschicht (5,15,16,17,18) auf mindestens eine für die Verbindung der Bauteile (1,2,11,12) vorgesehene Verbindungsfläche (23,24,25,26) zumindest eines der beiden Bauteile (1,2,11,12) aufgebracht wird und zum Aufschmelzen zumindest eines Teils des Lots ein über zwei unterschiedlich gepolte Elektroden (6a,6b) eingespeister elektrischer Strom durch die Lotschicht (5,15,16,17,18) geführt wird, wobei beide Elektroden (6a,6b) unmittelbar die Lotschicht (5,15,16,17,18) kontaktieren,
**dadurch gekennzeichnet, dass** die zwei Bauteile (1, 2, 11, 12) nicht metallisch leitend sind, damit der in das Lotmaterial eingespeiste elektrische Strom im Wesentlichen in der Lotschicht (5, 15, 16, 17, 18) verbleibt.

2. Verfahren nach Anspruch 1, **dadurch gekennzeichnet, dass** die Lotschicht (5,15,16,17,18) mittels physikalischer oder chemischer Gasphasenabscheidung aufgebracht wird.

3. Verfahren nach Anspruch 1, **dadurch gekennzeichnet, dass** die Lotschicht (5,15,16,17,18) mittels galvanischer Abscheidung aufgebracht wird.

4. Verfahren nach einem der vorherigen Ansprüche, **dadurch gekennzeichnet, dass** zur Herstellung von für den elektrischen Kontakt mit Elektroden (6a,6b) vorgesehenen Kontaktierungsflächen (19,20,21,22) die Lotschicht (5,15,16,17,18) über die Verbindungsfläche (23,24,25,26) hinaus aufgebracht wird.

5. Verfahren nach Anspruch 4, **dadurch gekennzeichnet, dass** die Lotschicht (5,15,16,17,18) im Bereich der Verbindungsfläche (23,24,25) in der vorgesehenen Stromrichtung gesehen mit einer gegenüber den Kontaktierungsflächen (19,20,21,22) geringeren Querschnittsfläche aufgebracht wird.

6. Verfahren nach Anspruch 4, **dadurch gekennzeichnet, dass** die bereits aufgebrachte Lotschicht (5,15,16,17,18) im Bereich der Verbindungsfläche (23,24,25) in ihrer Querschnittsfläche in der vorgesehenen Stromrichtung gesehen verringert wird.

7. Verfahren nach einem der vorherigen Ansprüche, **dadurch gekennzeichnet, dass** bei vorgegebener Stromstärke in der mindestens einen Verbindungsfläche (23,24,25,26) die Stromdichte in der Lotschicht (5,15,16,17,18) mittels mindestens eines magnetischen Feldes erhöht wird.

8. Verfahren nach einem der vorhergehenden Ansprüche, **dadurch gekennzeichnet, dass** vor dem Aufbringen der Lotschicht (5,15,16,17,18) mindestens eines der Bauteile (1,2,11,12) mit einer lotfähigen Schicht versehen wird.

9. Verfahren nach Anspruch 8, **dadurch gekennzeichnet, dass** mindestens eines der Bauteile (1,2,11,12) keramisch ist.

10. Verfahren nach Anspruch 8 und 9, **dadurch gekennzeichnet, dass** die Lotverbindung zwischen einer keramische Grundplatte (1) als eines der Bauteile und einer opto-elektronischen Komponente (2) als weiteres Bauteil hergestellt wird, wobei beide Bauteile mit der lotfähigen Schicht (3a, 3b) versehen werden.

11. Verfahren nach Anspruch 10, **dadurch gekennzeichnet, dass** die lotfähige Schicht (3a) aus Gold besteht.

## Claims

1. Method for producing a solder connection between two components (1, 2, 11, 12), in which method a solder layer (5, 15, 16, 17, 18) is applied to at least one connection surface (23, 24, 25, 26) of at least one of the two components (1, 2, 11, 12), which surface is provided for the connection of the components (1, 2, 11, 12), and an electric current fed in via two differently polarized electrodes (6a, 6b) is conducted through the solder layer (5, 15, 16, 17, 18) in order to melt at least part of the solder, the two electrodes (6a, 6b) directly contacting the solder layer (5, 15, 16, 17, 18), **characterized in that** the two components (1, 2, 11, 12) are not metallically conductive, such that the electric current fed into the solder material remains substantially in the solder layer (5, 15, 16, 17, 18).

2. Method according to claim 1, **characterized in that** the solder layer (5, 15, 16, 17, 18) is applied by means of physical or chemical vapor deposition.

3. Method according to claim 1, **characterized in that** the solder layer (5, 15, 16, 17, 18) is applied by means of electrodeposition.

4. Method according to any of the preceding claims, **characterized in that** the solder layer (5, 15, 16, 17, 18) is applied beyond the connection surface (23, 24, 25, 26) in order to produce contact surfaces (19, 20, 21, 22) provided for electrically contacting electrodes (6a, 6b).

5. Method according to claim 4, **characterized in that** the solder layer (5, 15, 16, 17, 18) is applied in the region of the connection surface (23, 24, 25), seen in the provided current direction, with a smaller cross-sectional area compared to the contact surfaces (19, 20, 21, 22).

6. Method according to claim 4, **characterized in that** the cross-sectional area, seen in the provided current direction, of the already applied solder layer (5, 15, 16, 17, 18) in the region of the connection surface (23, 24, 25) is reduced.

7. Method according to any of the preceding claims, **characterized in that**, at a predetermined current intensity in the at least one connection surface (23, 24, 25, 26), the current density in the solder layer (5, 15, 16, 17, 18) is increased by means of at least one magnetic field.

8. Method according to any of the preceding claims, **characterized in that**, prior to the application of the solder layer (5, 15, 16, 17, 18), at least one of the components (1, 2, 11, 12) is provided with a solderable layer.

9. Method according to claim 8, **characterized in that** at least one of the components (1, 2, 11, 12) is ceramic.

10. Method according to claim 8 and claim 9, **characterized in that** the solder connection is produced between a ceramic base plate (1) as one of the components and an opto-electronic component (2) as a further component, the two components being provided with the solderable layer (3a, 3b).

11. Method according to claim 10, **characterized in that** the solderable layer (3a) consists of gold.

## Revendications

1. Procédé de réalisation d'une liaison soudée entre deux composants (1, 2, 11, 12), dans lequel une couche de soudure (5, 15, 16, 17, 18) est appliquée sur au moins une surface de liaison (23, 24, 25, 26) d'au moins un des deux composants (1, 2, 11, 12), prévue pour la liaison des composants (1, 2, 11, 12), et un courant électrique alimenté par l'intermédiaire de deux électrodes (6a, 6b) polarisées différemment traverse la couche de soudure (5, 15, 16, 17, 18) pour fondre au moins une partie de la soudure, les deux électrodes (6a, 6b) étant en contact direct avec la couche de soudure (5, 15, 16, 17, 18), **caractérisé en ce que** les deux composants (1, 2, 11, 12) ne sont pas métalliquement conducteurs, de sorte que le courant électrique alimentant le matériau de soudure demeure essentiellement dans la couche de soudure (5, 15, 16, 17, 18).

2. Procédé selon la revendication 1, **caractérisé en ce que** la couche de soudure (5, 15, 16, 17, 18) est appliquée par dépôt en phase vapeur physique ou chimique.

3. Procédé selon la revendication 1, **caractérisé en ce que** la couche de soudure (5, 15, 16, 17, 18) est appliquée par électrodéposition.

4. Procédé selon l'une quelconque des revendications précédentes, **caractérisé en ce que** la couche de soudure (5, 15, 16, 17, 18) est appliquée au-delà de la surface de liaison (23, 24, 25, 26) afin de former des surfaces de contact (19, 20, 21, 22) prévues pour le contact électrique avec des électrodes (6a, 6b).

5. Procédé selon la revendication 4, **caractérisé en ce que** la couche de soudure (5, 15, 16, 17, 18), vue dans la direction de courant prévue, est appliquée dans la zone de la surface de liaison (23, 24, 25) avec une surface de section transversale inférieure aux surfaces de contact (19, 20, 21, 22).

6. Procédé selon la revendication 4, **caractérisé en ce que** la couche de soudure (5, 15, 16, 17, 18) déjà appliquée dans la zone de la surface de liaison (23, 24, 25) est réduite dans sa surface de section transversale, vue dans la direction de courant prévue.

7. Procédé selon l'une quelconque des revendications précédentes, **caractérisé en ce qu'** en cas d'une intensité de courant prédéterminée dans l'au moins une surface de liaison (23, 24, 25, 26) la densité de courant dans la couche de soudure (5, 15, 16, 17, 18) est augmentée au moyen d'au moins un champ magnétique avec une.

8. Procédé selon l'une quelconque des revendications précédentes, **caractérisé en ce qu'**au moins l'un des composants (1, 2, 11, 12) est pourvu d'une couche apte au soudage avant l'application de la couche de soudure (5, 15, 16, 17, 18).

9. Procédé selon la revendication 8, **caractérisé en ce qu'**au moins l'un des composants (1, 2, 11, 12) est en céramique.

10. Procédé selon la revendication 8 et 9, **caractérisé en ce que** la liaison soudée est réalisée entre une plaque de base en céramique (1) en tant que l'un des composants et un composant optoélectronique (2) en tant que composant supplémentaire, les deux composants étant pourvus de la couche (3a, 3b) apte au soudage.

11. Procédé selon la revendication 10, **caractérisé en ce que** la couche apte au soudage (3a) est en or.
